# EUROPEAN PATENT SPECIFICATION

(11) **EP 2 621 072 B1**
(45) Date of publication and mention of the grant of the patent: **26.06.2019**
(21) Application number: 12195598.3
(22) Date of filing: 05.12.2012
(51) Int. Cl.: H02M 7/48, H02P 3/18, H02M 1/08, H02M 1/084

(54) **Motor control device**
Motorsteuervorrichtung
Dispositif de commande de moteur

(30) Priority: 25.01.2012 JP 2012013265
(43) Date of publication of application: 31.07.2013
(73) Proprietor: Mitsubishi Electric Corporation, Chiyoda-ku Tokyo 100-8310 (JP)
(72) Inventor: Sunada, Hiroshi, Tokyo, 100-8310 (JP); Sakai, Akira, Japan, 100-8310 (JP)
(74) Representative: Pfenning, Meinig & Partner mbB

(56) References cited:
- JP-A- 2000 308 332
- JP-A- 2010 181 110
- US-A1- 2010 308 764

## Description

### BACKGROUND OF THE INVENTION

### 1. Field of the Invention

The present invention relates to a motor control device that controls a motor.

### 2. Description of the Related Art

A conventional motor control device includes an inverter control circuit. The inverter control circuit is constituted by three upper-arm switching elements (such as insulated gate bipolar transistors (IGBTs) or metal-oxide semiconductor field-effect transistors (MOS-FETs)), three lower-arm switching elements, a high-voltage-side drive circuit that is connected to gates of the upper-arm switching elements, a low-voltage-side drive circuit that is connected to gates of the lower-arm switching element, and a fly-wheel diode that is connected in parallel with the six switching elements. A drive signal is input from a control unit such as a microcomputer to the high-voltage-side drive circuit and the low-voltage-side drive circuit, and the high-voltage-side drive circuit and the low-voltage-side drive circuit execute a control of ON and OFF of the switching elements so as to control an output voltage from a connection point of the upper-arm switching element and the lower-arm switching element. In the conventional motor control device having such a configuration, a power supply is commonly used in an IC power supply that serves as a power supply unit of an inverter control circuit and a bootstrap power supply. Such a device is for example shown in Japanese Laid-open Patent Publication No. 2010-181110. Further, US2010308764 shows a motor controller comprising a processor with upper and lower arm switching elements, gate drivers, and a bootstrap capacitor which is configured to be charged while the upper arm switching element is turned off and which behaves as a voltage supply for the gate driver while the upper arm switching element is turned on.

However, the conventional motor control device described such as the Japanese Laid-open Patent Publication No. 2010-181110 is configured such that an output of an output voltage is stopped by shutting down (reducing the voltage) the power supply of both the high-voltage-side drive circuit and the low-voltage-side drive circuit, that is, the common power supply described above. Therefore, depending on the characteristics of the switching elements or configurations of the high-voltage drive circuit and the low-voltage drive circuit, drive voltages of the upper-arm switching element and the lower-arm switching element become unstable, and there is a possibility that an output of the output voltage is short-circuited.

The present invention has been achieved to solve the above problems, and an object of the present invention is to provide a motor control device that can stop an output of an output voltage in a stable state.

### SUMMARY OF THE INVENTION

It is an object of the present invention to at least partially solve the problems in the conventional technology.

According to an aspect of the present invention a motor control device includes: an inverter control circuit; a computing device that computes a control signal for controlling each of the first drive circuits and the second drive circuit; and a switch element that shuts down a power supply for charging the bootstrap capacitor when an operation to stop an output of the control circuit is performed. The inverter control circuit includes: a plurality of upper-arm switching elements that are connected to a positive terminal of a DC power supply; a plurality of first drive circuits that operate with an accumulated charge of a bootstrap capacitor as a power supply to drive each of the upper-arm switching elements; a plurality of lower-arm switching elements that are respectively connected in series with the upper-arm switching elements; and a second drive circuit that drives each of the lower-arm switching elements, and that converts a DC voltage into an AC voltage to drive and control a motor.

### BRIEF DESCRIPTION OF THE DRAWINGS

FIG. 1 is a configuration diagram of a motor control device according to a first embodiment of the present invention;
FIG. 2 is a time chart of an operation sequence of the motor control device illustrated in FIG. 1;
FIG. 3 is a configuration diagram of a motor control device according to a second embodiment of the present invention;
FIG. 4 is a time chart of an operation sequence of the motor control device illustrated in FIG. 3;
FIG. 5 is a configuration diagram of a motor control device according to a third embodiment of the present invention;
FIG. 6 is a time chart of an operation sequence of the motor control device illustrated in FIG. 5;
FIG. 7 is a configuration diagram of a motor control according to a fourth embodiment of the present invention; and
FIG. 8 is a time chart of an operation sequence of the motor control device illustrated in FIG. 7.

### DETAILED DESCRIPTION OF THE PREFERRED EMBODIMENTS

Exemplary embodiments of a motor control device according to the present invention will be explained below in detail with reference to the accompanying drawings. The present invention is not limited to the embodiments.

### First embodiment

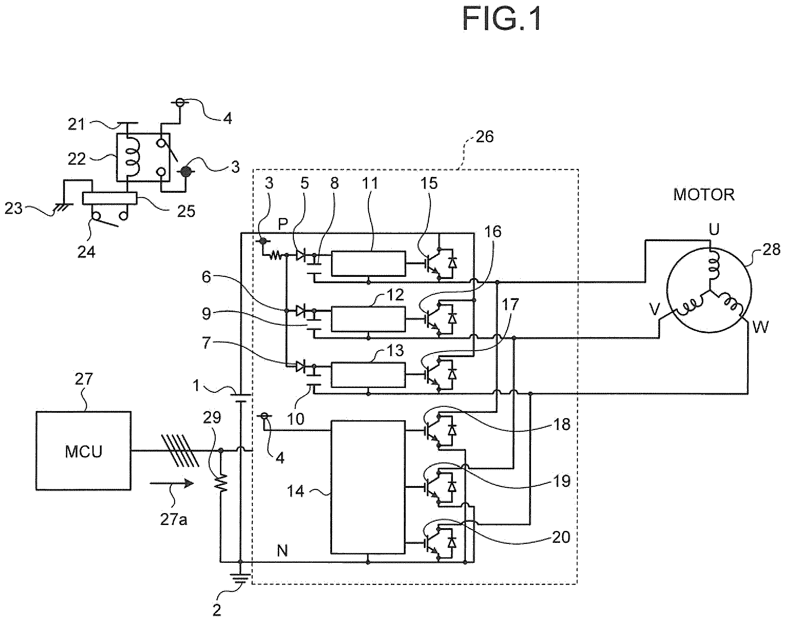

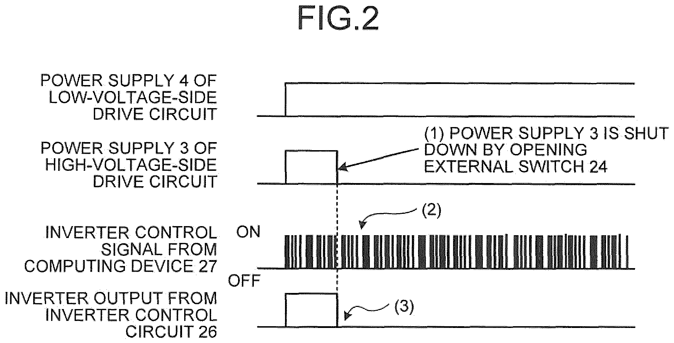

FIG. 1 is a configuration diagram of a motor control device according to a first embodiment of the present invention. The motor control device illustrated in FIG. 1 is configured to shut down a bootstrap power supply (a power supply 3 of high-voltage drive circuits 11, 12, and 13) when an operation to shut down an external switch 24 is performed. FIG. 2 is a time chart of an operation sequence of the motor control device illustrated in FIG. 1.

The motor control device illustrated in FIG. 1 mainly includes an inverter control circuit 26 that drives a motor 28, a computing device 27 (for example, a micro control unit (MCU)) that computes an inverter control signal 27a that serves as a control command of the inverter control circuit 26, and a switch element 22 (for example, a relay) that stops an inverter output from the inverter control circuit 26.

The inverter control circuit 26 includes three switching elements (such as IGBTs and MOS-FETs) 15, 16, and 17 that are connected to a high-level side of a direct current (DC) power supply 1; the high-voltage drive circuits 11 to 13 that serve as gate drive circuits respectively provided in gates of the switching elements 15 to 17; three switching elements 18, 19, and 20 that are connected to a low-level side of the DC power supply 1; and a low-voltage drive circuit 14 that serves as a gate drive circuit respectively provided in gates of the switching elements 18 to 20.

A series circuit that includes the switching element 15 and the switching element 18; a series circuit that includes the switching element 16 and the switching element 19; and a series circuit that includes the switching element 17 and the switching element 20, respectively, are connected to the DC power supply 1. A fly-wheel diode is connected to each of the switching elements 15 to 20 in an inverse-parallel manner. The three switching elements 15 to 17 and the fly-wheel diode constitute an upper arm, and the three switching elements 18 to 20 and the fly-wheel diode constitute a lower arm. Connection points between the switching elements 15 to 17 and the switching elements 18 to 20 respectively constitute output terminals U, V, and W to the motor 28. A U-phase connection, a V-phase connection, and a W-phase connection are connected to the output terminals U, V, and W, respectively; and the U-phase connection, V-phase connection, and W-phase connection are connected to the motor 28.

The inverter control signal 27a is supplied from the computing device 27 to the high-voltage drive circuits 11 to 13 and the low-voltage drive circuit 14. The high-voltage drive circuits 11 to 13 and the low-voltage drive circuit 14 supply a gate signal to the gates of the corresponding switching elements 15 to 20 based on the inverter control signal 27a; and the switching elements 15 to 20 perform a switching operation in response to the gate signal. This operation converts a DC voltage applied to the inverter control circuit 26 into a three-phase alternate current (AC) voltage having an arbitrary frequency, thereby driving the motor 28. A resistor 29 that detects the inverter control signal 27a is provided between the low-level side of the DC power supply 1 and an output unit of the computing device 27.

A power supply 4 is supplied to a power supply terminal of the low-voltage drive circuit 14 for the lower arm, and the power supply 3 is supplied to power supply terminals of the high-voltage drive circuits 11 to 13 for the upper arm. A reverse-current preventing rectifier diode 5 is provided between the high-voltage drive circuit 11 and the power supply 3. One end of a bootstrap capacitor 8, in which the other end thereof is connected to an emitter of the switching element 15, is connected to a connection end of the rectifier diode 5 and the high-voltage drive circuit 11. Similarly, a reverse-current preventing rectifier diode 6 is provided between the high-voltage drive circuit 12 and the power supply 3, and one end of a bootstrap capacitor 9, in which the other end thereof is connected to an emitter of the switching element 16, is connected to a connection end of the rectifier diode 6 and the high-voltage drive circuit 12. Furthermore, a reverse-current preventing rectifier diode 7 is provided between the high-voltage drive circuit 13 and the power supply 3, and one end of a bootstrap capacitor 10, in which the other end thereof is connected to an emitter of the switching element 17, is connected to a connection end of the rectifier diode 7 and the high-voltage drive circuit 13. In this manner, a bootstrap drive circuit is used in the inverter control circuit 26 according to the first embodiment. The emitter side of each of the switching elements 18 to 20 constitutes a reference GND in the inverter control circuit 26, and the power supply of the high-voltage drive circuits 11 to 13 is generated such that the switching elements 18 to 20 can be driven even when these elements are in an OFF state. In other words, the bootstrap capacitors 8 to 10 are charged when the switching elements 18 to 20 are turned OFF, and charges accumulated in the bootstrap capacitors 8 to 10 are used as the power supply of the high-voltage drive circuits 11 to 13 when the switching elements 18 to 20 are turned OFF.

The switch element 22 and the external switch 24 will be explained next. A voltage of a power supply 21 based on a GND 23 is applied to a primary-side coil of the switch element 22. The power supply 3 of the high-voltage drive circuits 11 to 13 is applied to one end of a secondary-side switch of the switch element 22, and the power supply 4 of the low-voltage drive circuit 14 is supplied to the other end of the secondary-side switch of the switch element 22. The power supply 21 is provided in a state insulated from the power supplies 3 and 4, and the GND 23 is insulated from a GND 2, which serves as a voltage-level reference of the power supplies 3 and 4. The external switch 24 is an operation unit that is provided outside of the motor control device and is operated by a user to shut down the power supply 3. The external switch 24 is provided between one end of the primary-side coil of the switch element 22 and the GND 23. In FIG. 1, as an example, the external switch 24 is provided between one end of the primary-side coil of the switch element 22 and the GND 23 with a connector 25 interposed therebetween.

An operation of the motor control device will be explained with reference to FIG. 2. (1) When a user opens the external switch 24, a voltage applied to the primary-side coil of the switch element 22 is lost so as to put the secondary-side switch of the switch element 22 into an opened state, thereby separating the power supplies 3 and 4 from each other. At this time, the power supply 3 supplied to the high-voltage drive circuits 11, 12, and 13 is shut down. When the power supply 3 is shut down, charges that are charged in the bootstrap capacitors 8 to 10 are discharged, and the high-voltage drive circuits 11 to 13 stop functioning. Therefore, the switching elements 15 to 17 cannot be turned ON. (2) The inverter control signal 27a is input from the computing device 27 to the inverter control circuit 26; however, (3) the power supply 4 of the low-voltage drive circuit 14, which is based on the GND 2, is not shut down when the power supplies 3 and 4 are separated from each other. Therefore, drive voltages of the switching elements 18 to 20 are stable, and thus the operation of the inverter control circuit 26 does not become unstable. Accordingly, the inverter output from the inverter control circuit 26 is stably kept to be OFF in a stable state.

As explained above, the motor control device according to the first embodiment includes the inverter control circuit 26, the computing device 27, and the switch element 22. The inverter control circuit 26 includes a plurality of upper-arm switching elements (the switching elements 15 to 17) that are connected to a positive terminal of the DC power supply 1, a plurality of first drive circuits (the high-voltage drive circuits 11 to 13) that are operated with an accumulated charge of the bootstrap capacitors 8 to 10 as a power supply to respectively drive the switching elements 15 to 17, a plurality of lower-arm switching elements (the switching elements 18 to 20) that are connected in series with the switching elements 15 to 17, and a second drive circuit (the low-voltage drive circuit 14) that drives each of the switching elements 18 to 20. The inverter control circuit 26 converts a DC voltage into an AC voltage to drive and control the motor 28. The computing device 27 computes a control signal (the inverter control signal 27a) for controlling the high-voltage drive circuits 11 to 13 and the low-voltage drive circuit 14. The switch element 22 shuts down the power supply 3 for charging the bootstrap capacitors 8 to 10 when an operation to stop an inverter output of the inverter control circuit 26 is performed. With this configuration, even when a shutdown operation is performed in the external switch 24, the power supply 4 of the low-voltage drive circuit 14 is not shut down, and only operations of the switching elements 15 to 17 become OFF. As a result, the inverter output can be surely and safely stopped irrespective of the characteristics of the switching element and the configurations of the high-voltage drive circuit and the low-voltage drive circuit. Furthermore, the motor control device according to the first embodiment is configured such that an operation to stop the inverter output is performed by the external switch 24 provided outside of the motor control device, so that a user can intentionally and safely stop the inverter output.

### Second embodiment

The motor control device according to the first embodiment is configured such that an inverter output is stopped by shutting down the power supply 3 of the bootstrap capacitors 8 to 10 when the external switch 24 is operated. However, in the motor control device according to the first embodiment, the inverter output is not stopped for a predetermined period of time since the power supply 3 is shut down, because the switching elements 15 to 17 are not turned OFF due to the charges of the bootstrap capacitors 8 to 10. A motor control device according to a second embodiment of the present invention is configured such that, when the external switch 24 is operated, the power supply 3 of the bootstrap capacitors 8 to 10 is shut down, and at the same time the inverter output is stopped by stopping the inverter control signal 27a to be output to the inverter control circuit 26. In the second embodiment, elements identical to those in the first embodiment are denoted by like reference signs, redundant explanations thereof will be omitted, and only elements different from those in the first embodiment are explained below.

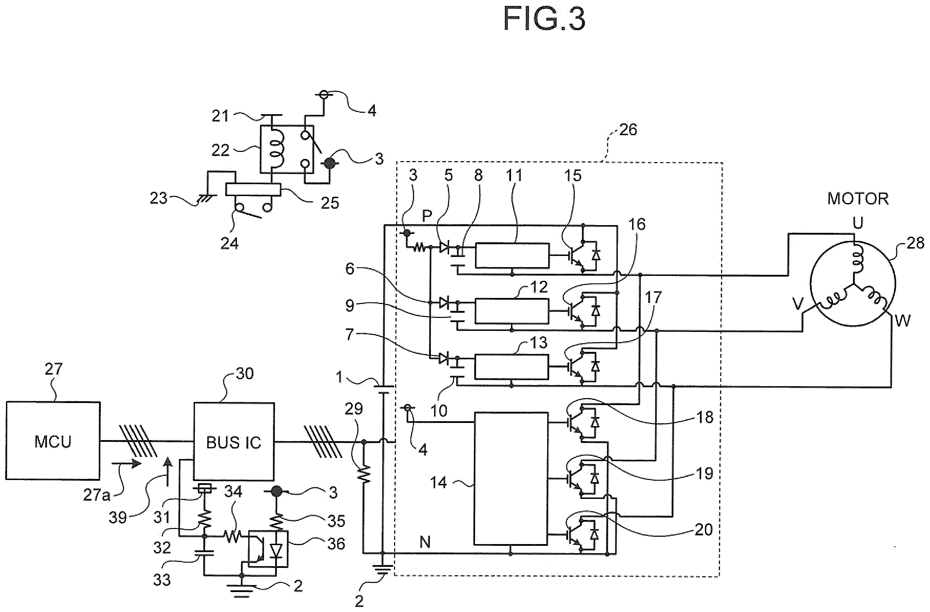

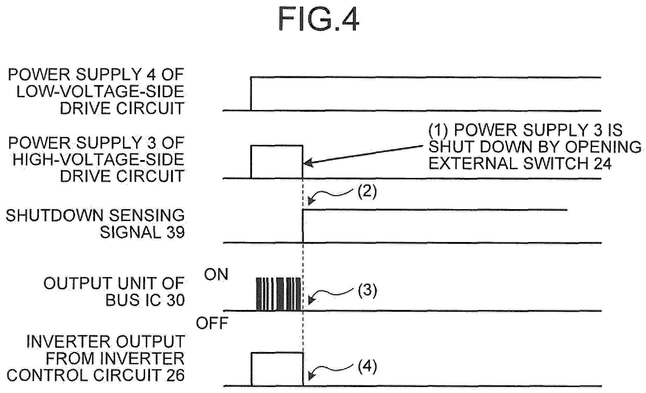

FIG. 3 is a configuration diagram of the motor control device according to the second embodiment, and FIG. 4 is a time chart of an operation sequence of the motor control device illustrated in FIG. 3.

In the motor control device illustrated in FIG. 3, a bus IC 30 is provided between the computing device 27 and the inverter control circuit 26. In the bus IC 30, for example, when a signal input to a minus input unit is at a low level, a signal input to other input units is usually output, and when the signal input to the minus input unit is changed to a high level, all the outputs become high impedance. A shutdown sensing signal 39 is input to the minus input unit of the bus IC 30. The shutdown sensing signal 39 is a voltage value within an input voltage range of the bus IC 30, and indicates that a power supply 31 is shut down. The inverter control signal 27a is input from the computing device 27 to other input units of the bus IC 30. An output unit of the bus IC 30 is connected to the inverter control circuit 26, and one end of the resistor 29 is connected to the output unit.

The circuit that generates the shutdown sensing signal 39 described above is constituted by, for example, a switch element 36 (such as a photocoupler), a resistor 35 that is connected between a primary side of the switch element 36 and the power supply 3 to control the switch element 36, a resistor 34 that is connected between a secondary side of the switch element 36 and an input unit (the minus input unit) of the bus IC 30, a resistor 32 in which one end thereof is connected to the power supply 31 while the other end thereof is connected to a connection unit of an input unit (the minus input unit) of the bus IC 30 and the resistor 34, and a filter capacitor 33 in which one end thereof is connected to the other end of the resistor 32 while the other end thereof is connected to the secondary side of the switch element 36.

An operation of the motor control device according to the second embodiment will be explained with reference to FIG. 4. (1) When a user opens the external switch 24, a voltage applied to the primary-side coil of the switch element 22 is lost so as to put the secondary-side switch of the switch element 22 into an opened state, thereby separating the power supplies 3 and 4 from each other. At this time, the power supply 3 supplied to the high-voltage drive circuits 11, 12, and 13 is shut down. (2) When the power supply 3 is shut down, a high-level signal (the shutdown sensing signal 39) is input to the minus input unit of the bus IC 30. (3) At this time, the output of the bus IC 30 becomes high impedance, and the output of the bus IC 30 is fixed to a low level. (4) With this configuration, even when the inverter control signal 27a is input from the computing device 27 to other input units of the bus IC 30, only a low-level signal is input to the inverter control circuit 26 due to a voltage-dividing relationship between the output impedance of the bus IC 30 and the resistor 29. That is, the inverter control signal 27a is not input to the inverter control circuit 26. When it is assumed that the switching elements 15 to 20 are turned OFF when the inverter control signal 27a input to the inverter control circuit 26 is turned OFF, the inverter control circuit 26 stops the inverter output.

As described above, the motor control device according to the second embodiment is configured to include a signal control unit (the bus IC 30) that is provided between the computing device 27 and the inverter control circuit 26, outputs the inverter control signal 27a supplied from the computing device 27 to the inverter control circuit 26 when the shutdown sensing signal 39 indicating that the power supply 3 for charging the bootstrap capacitors 8 to 10 is shut down is not input, and does not output the inverter control signal 27a to the inverter control circuit 26 when the shutdown sensing signal 39 is input. Therefore, the inverter output can be stopped when the power supply 3 is shut down.

### Third embodiment

The motor control device according to the first embodiment is configured such that an inverter output is stopped by shutting down the power supply 3, and in the configuration of the motor control device according to the second embodiment, shutdown of the power supply 3 is sensed to fix the inverter control signal 27a input to the inverter control circuit 26 to a low level, thereby stopping the inverter output. However, in the motor control devices according to the first and second embodiments, an output of the inverter control signal 27a supplied from the computing device 27 is continued even when the power supply 3 is shut down. Therefore, for example, when an output of the bus IC 30 is short-circuited while the switching elements 15 to 17 are not turned OFF, the inverter output is not stopped because the switching elements 15 to 17 are not turned OFF due to the charges of the bootstrap capacitors 8 to 10 for a predetermined period of time since the power supply 3 is shut down. A motor control device according to a third embodiment of the present invention is configured to be able to stop the inverter output even in such a case. In the third embodiment, elements identical to those in the second embodiment are denoted by like reference signs, redundant explanations thereof will be omitted, and only elements different from those in the second embodiment are explained below.

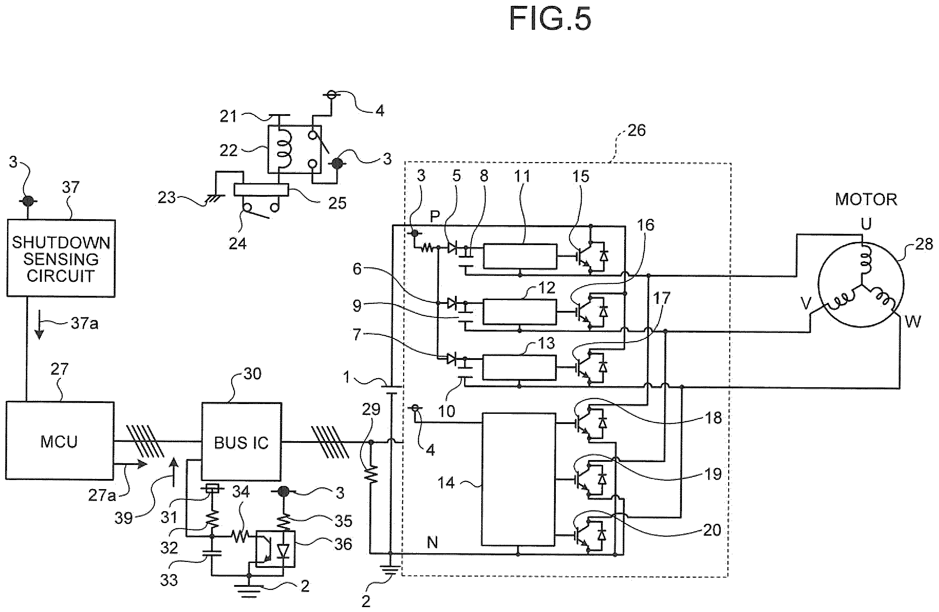

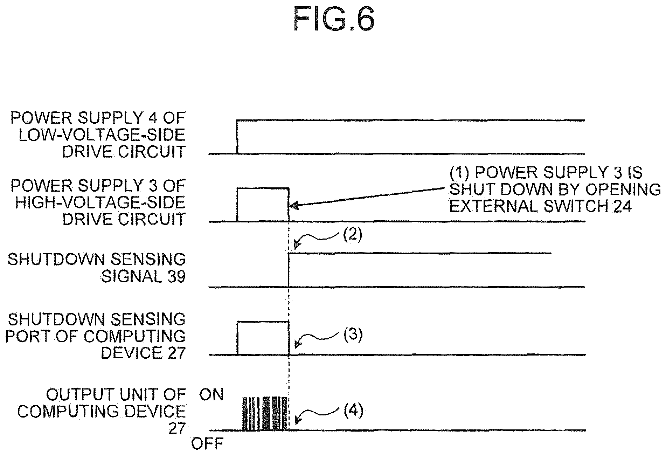

FIG. 5 is a configuration diagram of the motor control device according to the third embodiment, and FIG. 6 is a time chart of an operation sequence of the motor control device illustrated in FIG. 5.

In the motor control device illustrated in FIG. 5, a shutdown sensing circuit 37 is provided between the computing device 27 that controls an inverter output and the power supply 3. The shutdown sensing circuit 37 senses shutdown of the power supply 3. A shutdown sensing port is provided in the computing device 27 in order to fetch a signal 37a from the shutdown sensing circuit 37. When the signal 37a from the shutdown sensing circuit 37 changes to a low level, the computing device 27 senses shutdown of the power supply 3, and then fixes the output of the inverter control signal 27a to a low level.

An operation of the motor control device according to the third embodiment will be explained with reference to FIG. 6. (1) When a user opens the external switch 24, a voltage applied to the primary-side coil of the switch element 22 is lost so as to put the secondary-side switch of the switch element 22 into an opened state, thereby separating the power supplies 3 and 4 from each other. At this time, the power supply 3 supplied to the high-voltage drive circuits 11, 12, and 13 is shut down. When the power supply 3 is shut down, (2) a high-level signal is input to the minus input unit of the bus IC 30, and (3) the signal 37a input to the shutdown sensing port of the computing device 27 changes to a low level. (4) Therefore, the output of the inverter control signal 27a supplied from the computing device 27 is fixed to a low level, and as a result, the inverter output from the inverter control circuit 26 is stopped.

As described above, the motor control device according to the third embodiment includes the shutdown sensing circuit 37 that senses shutdown of the power supply 3 for charging the bootstrap capacitors 8 to 10, and the computing device 27 senses the shutdown of the power supply 3 based on the signal 37a from the shutdown sensing circuit 37 to fix the output of the inverter control signal 27a to a low level. Therefore, the inverter output can be stopped when the power supply 3 is shut down.

### Fourth embodiment

The motor control device according to the first embodiment is configured such that an inverter output is stopped by shutting down the power supply 3. In the configuration of the motor control device according to the second embodiment, shutdown of the power supply 3 is sensed to fix the inverter control signal 27a input to the inverter control circuit 26 to a low level, thereby stopping the inverter output. In the configuration of the motor control device according to the third embodiment, shutdown of the power supply 3 is sensed by the computing device 27 to fix the inverter control signal 27a supplied from the computing device 27 to a low level, thereby stopping the inverter output. However, in the motor control device according to the first to third embodiments, when a secondary-side switch of the switch element 22 becomes a short-circuit state, the inverter output cannot be stopped, because the power supply 3 cannot be shut down even when the external switch 24 is opened. A motor control device according to a fourth embodiment of the present invention is configured to be able to stop the inverter output even in such a case. In the fourth embodiment, elements identical to those in the third embodiment are denoted by like reference signs, redundant explanations thereof will be omitted, and only elements different from those in the third embodiment are explained below.

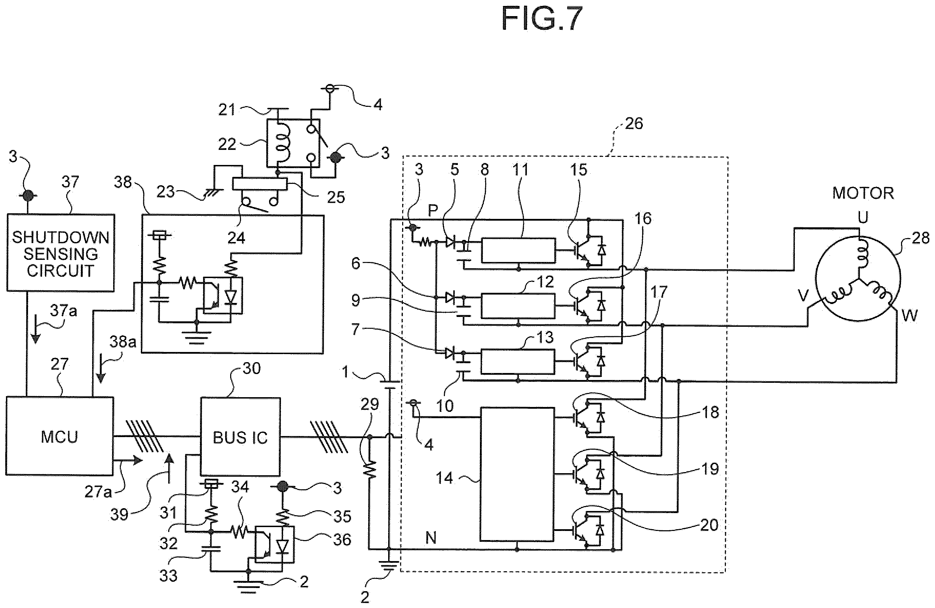

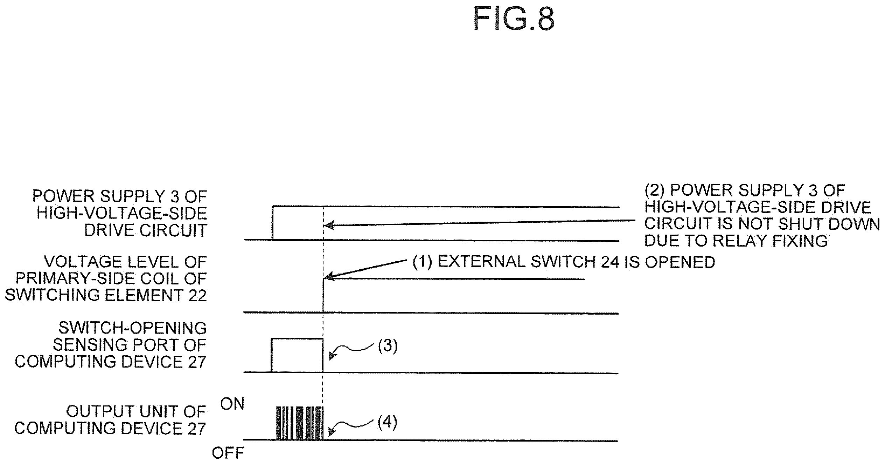

FIG. 7 is a configuration diagram of the motor control according to the fourth embodiment, and FIG. 8 is a time chart of an operation sequence of the motor control device illustrated in FIG. 7.

A stopping-operation detection circuit 38 is provided in the motor control device illustrated in FIG. 7. The stopping-operation detection circuit 38 is connected to a connection unit of the primary-side coil of the switch element 22 and the external switch 24, and detects an operation to stop the inverter output of the inverter control circuit 26. For example, the stopping-operation detection circuit 38 senses opening of the external switch 24, and outputs the information to the computing device 27. A switch-opening sensing port is provided in the computing device 27 in order to fetch a signal 38a from the stopping-operation detection circuit 38. When the signal 38a from the stopping-operation detection circuit 38 changes to a low level, the computing device 27 senses the opening of the external switch 24 to fix the output of the inverter control signal 27a to a low level.

An operation of the motor control device according to the fourth embodiment will be explained with reference to FIG. 8. (1) When a user opens the external switch 24, a voltage applied to the primary-side coil of the switch element 22 is lost. (2) At this time, the power supply 3 cannot be shut down in a case where the secondary-side switch of the switch element 22 is in a short-circuited state. (3) However, because the stopping-operation detection circuit 38 detects an operation to open the external switch 24, a signal input to the switch-opening sensing port of the computing device 27 changes to a low level. (4) Therefore, the output of the inverter control signal 27a supplied from the computing device 27 is fixed to a low level, and as a result, the inverter output from the inverter control circuit 26 is stopped.

As described above, the motor control device according to the fourth embodiment includes the stopping-operation detection circuit 38 that detects an operation to stop the output of the inverter control circuit 26, and the computing device 27 senses the operation to stop the output of the inverter control circuit 26 based on the signal 38a supplied from the stopping-operation detection circuit 38 to fix the output of the inverter control signal 27a to a low level. Therefore, even when the secondary-side switch of the switch element 22 becomes a short-circuit state, the inverter output can be stopped when an operation of the external switch 24 is performed.

According to the present invention, only a drive power supply of a high-voltage-side drive circuit is shut down from outside, so that an output of an output voltage can be stopped in a stable state.

## Claims

1. A motor control device that converts a DC voltage into an AC voltage to drive and control a motor (28) comprising:
an inverter control circuit (26) that includes:
a plurality of upper-arm switching elements (15, 16, 17) that is connected to a positive terminal of a DC power supply (1);
a plurality of first drive circuits (11, 12, 13) that operates with an accumulated charge of a bootstrap capacitor (8, 9, 10) as a power supply to drive each of the upper-arm switching elements (15, 16, 17);
a plurality of lower-arm switching elements (18, 19, 20) that is respectively connected in series with the upper-arm switching elements (15, 16, 17); and a computing device (27) that computes a control signal for controlling each of the first drive circuits (11, 12, 13), **characterized by**
a second drive circuit (14) configured to drive each of the lower-arm switching elements (18, 19, 20), and
a switch element (22) configured to shut down only a power supply for charging the bootstrap capacitor (8, 9, 10) when an operation to stop an output of the control circuit (26) is performed; wherein the computing device (27) configured to compute a control signal for controlling of the second drive circuit (14).

2. The motor control device according to claim 1, further comprising a signal control unit (30) that is provided between the computing device (27) and the inverter control circuit (26), outputs a control signal from the computing device (27) to the inverter control circuit (26) when a shutdown sensing signal indicating shutdown of the power supply for charging the bootstrap capacitor (8, 9, 10) is not input, and not to output a control signal from the computing device (27) to the inverter control circuit (26) when the shutdown sensing signal is input.

3. The motor control device according to claim 1 or 2, further comprising a shutdown sensing circuit (37) that senses shutdown of a power supply for charging the bootstrap capacitor (8, 9, 10), wherein
the computing device (27) senses shutdown of the power supply based on a signal from the shutdown sensing circuit (37) to fix an output of the control signal to a low level.

4. The motor control device according to any one of claims 1 to 3, further comprising a stopping-operation detection circuit (38) that detects an operation to stop an output of the control circuit, wherein
the computing device (27) senses an operation to stop an output of the control circuit based on a signal from the stopping-operation detection circuit (38) to fix the output of the control signal to a low level.

## Patentansprüche

1. Motorsteuervorrichtung, die eine DC-Spannung in eine AC-Spannung umwandelt, zum Antreiben und Steuern eines Motors (28), umfassend:
eine Inverter-Steuerschaltung (26), die umfasst:
eine Mehrzahl von Schaltelementen eines oberen Zweiges (15, 16, 17), die mit einem positiven Anschluss einer DC-Leistungsversorgung (1) verbunden ist;
eine Mehrzahl von ersten Treiberschaltungen (11, 12, 13), die mit einer akkumulierten Ladung eines Bootstrap-Kondensators (8, 9, 10) als Leistungsversorgung zum Treiben eines jeden der Schaltelemente des oberen Zweiges (15, 16, 17) funktioniert;
eine Mehrzahl von Schaltelementen eines unteren Zweiges (18, 19, 20), die jeweils mit den Schaltelementen des oberen Zweiges (15, 16, 17) in Reihe geschaltet ist; und
eine Rechenvorrichtung (27), die ein Steuersignal zum Steuern einer jeden der ersten Treiberschaltungen (11, 12, 13) berechnet, **gekennzeichnet durch**
eine zweite Treiberschaltung (14), die zum Treiben eines jeden der Schaltelemente (18, 19, 20) des unteren Zweiges konfiguriert ist, und
ein Schaltelement (22), das konfiguriert ist, um lediglich eine Leistungsversorgung zum Laden des Bootstrap-Kondensators (8, 9, 10) abzuschalten, wenn ein Vorgang zum Stoppen einer Ausgabe der Steuerschaltung (26) durchgeführt wird;
wobei die Rechenvorrichtung (27) zum Berechnen eines Steuersignals zum Steuern der zweiten Treiberschaltung (14) konfiguriert ist.

2. Motorsteuervorrichtung nach Anspruch 1, ferner umfassend eine Signalsteuereinheit (30), die zwischen der Rechenvorrichtung (27) und der Inverter-Steuerschaltung (26) vorgesehen ist, ein Steuersignal aus der Rechenvorrichtung (27) an die Inverter-Steuerschaltung (26) ausgibt, wenn ein Abschaltungserfassungssignal, das eine Abschaltung der Leistungsversorgung zum Laden des Bootstrap-Kondensators (8, 9, 10) anzeigt, nicht eingegeben wird und kein Steuersignal aus der Rechenvorrichtung (27) an die Inverter-Steuerschaltung (26) auszugeben, wenn das Abschaltungserfassungssignal eingegeben wird.

3. Motorsteuervorrichtung nach Anspruch 1 oder 2, ferner umfassend eine Abschaltungserfassungsschaltung (37), welche Abschaltung einer Leistungsversorgung zum Laden des Bootstrap-Kondensators (8, 9, 10) erfasst, wobei
die Rechenvorrichtung (27) Abschaltung der Leistungsversorgung basierend auf einem Signal von der Abschaltungserfassungsschaltung (37) erfasst, um eine Ausgabe des Steuersignals auf einen niedrigen Pegel setzen.

4. Motorsteuervorrichtung nach einem der Ansprüche 1 bis 3, ferner umfassend eine Stoppvorgang-Erkennungsschaltung (38), die einen Vorgang zum Stoppen einer Ausgabe der Steuerschaltung erkennt, wobei
die Rechenvorrichtung (27) einen Vorgang zum Stoppen einer Ausgabe der Steuerschaltung basierend auf einem Signal von der Stoppvorgang-Erkennungsschaltung (38) erfasst, um die Ausgabe des Steuersignals auf einen niedrigen Pegel zu setzen.

## Revendications

1. Dispositif de commande de moteur qui convertit une tension continue DC en tension alternative AC pour entraîner et commander un moteur (28), comprenant :
un circuit de commande d'onduleur (26) qui comprend :
une pluralité d'éléments de commutation dans la branche supérieure (15, 16, 17) qui sont connectés à une borne positive d'une alimentation DC (1) ;
une pluralité de premiers circuits de commande (11, 12, 13) qui fonctionnent avec une charge accumulée d'un condensateur élévateur de tension (8, 9, 10) en tant qu'alimentation pour commander chacun des éléments de commutation dans la branche supérieure (15, 16, 17) ;
une pluralité d'éléments de commutation dans la branche inférieure (18, 19, 20) qui sont connectés respectivement en série avec les éléments de commutation dans la branche supérieure (15, 16, 17) ; et
un dispositif de calcul (27) qui calcule un signal de commande destiné à commander chacun des premiers circuits de commande (11, 12, 13), **caractérisé par**
un second circuit de commande (14) configuré pour commander chacun des éléments de commutation dans la branche inférieure (18, 19, 20), et
un élément de commutation (22) configuré pour arrêter seulement une alimentation de charge du condensateur élévateur de tension (8, 9, 10), quand une opération visant à arrêter une sortie du circuit de commande (26) est exécutée ;
où le dispositif de calcul (27) est configuré pour calculer un signal de commande destiné à commander le second circuit de commande (14).

2. Dispositif de commande de moteur selon revendication 1, comprenant en outre une unité de commande de signal (30) qui est disposée entre le dispositif de calcul (27) et le circuit de commande d'onduleur (26), délivre en sortie au circuit de commande d'onduleur (26), un signal de commande provenant du dispositif de calcul (27), quand un signal de détection d'arrêt indiquant l'arrêt de l'alimentation de charge du condensateur élévateur de tension (8, 9, 10) n'est pas entré, et ne délivre pas en sortie au circuit de commande d'onduleur (26), un signal de commande provenant du dispositif de calcul (27), lorsque le signal de détection d'arrêt est entré.

3. Dispositif de commande de moteur selon la revendication 1 ou 2, comprenant en outre un circuit de détection d'arrêt (37) qui détecte un arrêt de l'alimentation de charge du condensateur élévateur de tension (8, 9, 10), où
le dispositif de calcul (27) détecte l'arrêt de l'alimentation sur la base d'un signal provenant du circuit de détection d'arrêt (37) pour placer une sortie du signal de commande à un niveau bas.

4. Dispositif de commande de moteur selon l'une quelconque des revendications 1 à 3, comprenant en outre un circuit de détection d'opération d'arrêt (38) qui détecte une opération visant à arrêter une sortie du circuit de commande, où
le dispositif de calcul (27) détecte une opération visant à arrêter une sortie du circuit de commande sur la base d'un signal provenant du circuit de détection d'opération d'arrêt (38) pour placer la sortie du signal de commande à un niveau bas.
